Europäisches Patentamt

European Patent Office

Office européen des brevets

(11) Publication number: **0 200 791**
**A1**

# EUROPEAN PATENT APPLICATION

published in accordance with Art. 158(3) EPC

(21) Application number: 85905436.3

(22) Date of filing: 05.11.85

Data of the international application taken as a basis:

(86) International application number:
**PCT/JP 85/00612**

(87) International publication number:
**WO 86/02994 (22.05.86 86/11)**

(51) Int. Cl.⁴: **G 01 B 7/00, G 01 B 21/00,
G 01 D 5/245**

(30) Priority: 05.11.84 JP 231353/84

(43) Date of publication of application: **12.11.86**
**Bulletin 86/46**

(84) Designated Contracting States: **DE FR GB**

(71) Applicant: **FANUC LTD, 3580, Shibokusa Aza-Komanba
Oshino-mura, Minamitsuru-gun Yamanashi 401-05 (JP)**

(72) Inventor: **SAKANO, Tetsuro, 1205-3-103, Shibokusa
Oshinomura, Minamitsuru-gun, Yamanashi 401-05 (JP)**

(74) Representative: **George, Sidney Arthur et al, GILL
JENNINGS & EVERY 53-64 Chancery Lane, London
WC2A 1HN (GB)**

(54) **METHOD AND APPARATUS FOR DETECTING POSITION.**

(57) A method of detecting a position comprising a step for generating two sinusoidal wave signals having phases that are spacially different by 90°, corresponding to the movement of a moving body; a step which detects voltages Va, Vb of the two sinusoidal wave signals to calculate a value $\alpha$ which makes the value $V = Va.\cos \alpha - Vb.\sin \alpha$ zero; and a step which detects the amount of movement of the moving body by using the above calculated value $\alpha$ as data on positions of interpolated division in a cycle of the sinusoidal wave; as well as an apparatus for detecting the position, which is used for putting said method into practice. According to the method and apparatus for detecting position, the moving position of the moving body can be detected with high resolution.

- 1 -

## DESCRIPTION

TITLE OF THE INVENTION

Method and Apparatus for Detecting Position

TECHNICAL FIELD

The present invention relates to a method and an apparatus for detecting a position and, more particularly, to a method and an apparatus for detecting a moving position of a working machine (e.g., an NC machine) or of the arms of a robot.

BACKGROUND ART

Position detection is conventionally performed by using two-phase sinusoidal wave signals (referred to as signals $V_a$ and $V_b$ hereinafter) having a 90°-spatial phase difference therebetween, and a position detecting apparatus of this type is generally called an encoder.

A conventional encoder irradiates light emitted from, e.g., a light-emitting diode, to a rotary encoding plate (normally provided with a large number of slits (e.g., 2,000) at equal intervals on the periphery thereof) mounted on a given rotating shaft, whose rotating position is to be detected. The light passed through a slit formed in the rotary encoding plate and a slit formed in a fixed plate facing the rotary encoding plate is received by a light-receiving element (e.g., a photodiode) to be converted into a voltage, thereby obtaining, in accordance with rotation of the rotary encoding plate, sinusoidal wave signals $V_a$ and $V_b$, one cycle of which corresponds to an interval between two adjacent slits (one pitch) formed in the rotary encoding plate.

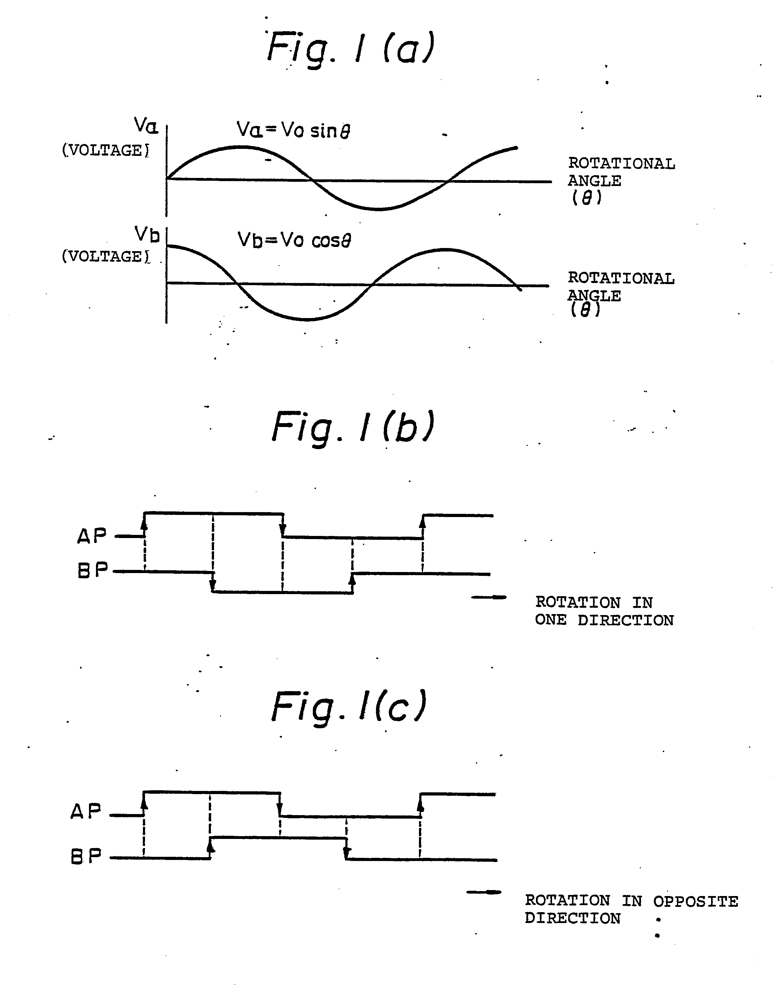

In this case, in order to provide the 90°-spatial phase difference between the two sinusoidal wave signals $V_a$ and $V_b$, two slits, shifted by 1/4 of a pitch from an integer multiple of the slit interval (1 pitch) of the rotary encoding plate, are formed in the fixed slit plate, and the two sinusoidal wave

signals $V_a$ and $V_b$ are obtained from the electrical signals generated in the light-receiving elements, each of which faces each of the above two slits (see Fig. 1(a)).

The sinusoidal wave signals $V_a$ and $V_b$ are input to comparators for generating output signals AP and BP, which go to HIGH or LOW level in accordance with positive or negative levels of the sinusoidal wave signals. A so-called positive pulse for sequentially counting up an up-down counter (meaning that the rotary encoding plate is rotated in a given direction, e.g., clockwise) is produced in the following states: ① when the output signal BP is at HIGH level at the leading edge of the output signal AP; ② when the output signal AP is at HIGH level at the trailing edge of the output signal BP; ③ when the output signal BP is at LOW level at the trailing edge of the output signal AP; and ④ when the output signal AP is at LOW level at the leading edge of the output signal BP (see Fig. 1(b)). On the other hand, a so-called negative pulse for sequentially counting down the up-down counter (meaning that the rotary encoding plate is rotated in the opposite direction, e.g., counterclockwise) is produced in the following states: ① when the output signal BP is at LOW level at the leading edge of the output signal AP; ② when the output signal AP is at LOW level at the trailing edge of the output signal BP; ③ when the output signal BP is at HIGH level at the trailing edge of the output signal AP; and ④ when the output signal AP is at HIGH level at the leading edge of the output signal BP (see Fig. 1(c)). In this manner, the rotational angle of the rotary encoding plate, i.e., a rotating position of the rotating shaft on which the rotary encoding plate is mounted, is detected (in some cases, the rotational angle of the rotary encoding plate is linearly developed, and the moving position of a linearly moving object is detected).

However, in this conventional position detecting method, only four pulses (the positive or negative pulses) for counting up or down the up-down counter are generated upon rotation of the rotary encoding plate during 1 cycle of the output signal AP or BP (corresponding to a 1-pitch interval of two adjacent slits in the rotary encoding plate), as described above. If 2,000 slits are formed in the periphery of the rotary encoding plate, the resolution of the rotational angle detection is only 1/(2,000 x 4) = 1/8,000 rotation. In other words, upon rotation of the rotary encoding plate, only a detection resolution corresponding to 4 times of a divisor for each rotation of the rotary encoding plate, corresponding to the number of slits, can be obtained.

DISCLOSURE OF THE INVENTION

The present invention has been made in consideration of the above situation, and its object is to detect a moving position of a rotating member or, in general, a moving object with reference to a moving amount (deviation amount) of the object from its initial position with a remarkably high detection resolution (e.g., 1/(2,000 x 1,000) rotation) when compared with that obtained in the above-mentioned conventional moving position detecting method.

In order to solve the above problem, according to an aspect of the present invention, there is provided a method for detecting a position, comprising the steps of producing two-phase sinusoidal wave signals having a 90°-spatial phase difference therebetween upon movement of a moving object; detecting the current voltage values $V_a$ and $V_b$ of the two-phase sinusoidal wave signals and calculating a value of $\alpha$ making a value of V zero, given by $V = V_a \cdot \cos\alpha - V_b \cdot \sin\alpha$; and detecting a moving amount of the moving object by using the calculated value of $\alpha$ as interpolating-dividing position data within 1 cycle of the sinusoidal wave signals.

According to another aspect of the present invention, there is provided an apparatus for detecting a position, comprising: means for producing two-phase sinusoidal wave signals having a 90°-spatial phase difference therebetween upon movement of a moving object; a cos converter and a sin converter for cos-converting and sin-converting a ratio of a count number of an up-down counter to an interpolating divisor within 1 cycle of the sinusoidal wave signals; two multiplying means for respectively producing a product between the output from the cos converter and the current voltage value $V_a$ of one of the two-phase sinusoidal wave signals and a product between the output from the sin converter and the current voltage value $V_b$ of the other of the two-phase sinusoidal wave signals, and subtracting means for deriving a difference V between the outputs from the two multiplying means; a compensator for compensating the value of the difference V; pulse generating means for generating pulses having a frequency proportional to an absolute value of the output from the compensator; and a polarity detector for detecting a polarity of the output from the compensator; wherein the up-down counter is caused to count up or down by a predetermined number of pulses in accordance with the output signal from the polarity detector, until the difference V becomes zero.

According to one aspect of the present invention, the value of $\alpha$ making the value of V zero, given by $V = V_a \cdot \cos\alpha - V_b \cdot \sin\alpha$, is calculated by using:
$$V_a = V_0 \sin\theta, \text{ and } V_b = V_0 \sin\theta$$
(where $\theta$ is a current rotational angle).
As a result, the value of $\alpha$ making the value V given by the following equation zero need only be calculated:
$$V = V_0 (\sin\theta \cdot \cos\alpha - \cos\theta \cdot \sin\alpha)$$
$$= V_0 \cdot \sin(\theta - \alpha)$$
In this case, the above equation becomes zero when $\alpha = \theta \pm n\pi$ (where n is an integer).

Therefore, when $\theta$ varies, if $\alpha$ is sequentially

obtained within a cycle shorter than the varying rate of $\theta$ (more specifically, a cycle shorter than a time in which the sinusoidal wave signals change by $\pi$), a deviation amount of $\theta$ can be accurately detected by obtaining a change in $\alpha$. In this case, the value of $\alpha$ making the value of V zero satisfies the above relation of $\alpha = \theta \pm n\pi$, regardless of the value of $V_0$, which makes a major cause of detection errors (the value of $V_0$ varies during one rotation of the rotary plate since a gap between the rotary encoding plate and the fixed slit plate varies upon rotation of the rotary encoding plate, and also varies due to a variation over time in the amount of light emitted from the light-emitting diode). As a result, 1 cycle of the sinusoidal wave signals (corresponding to a 1-pitch interval of the slits in the rotary encoding plate) is linearly interpolated and divided (i.e., equally divided) by a predetermined interpolating divisor (e.g., 1,000) by using the value of $\alpha$, and a deviation amount of the rotary encoding plate (in general, a moving amount of the moving object) can be detected with a remarkably high resolution (e.g., 1/(2,000 x 1,000) rotation if the number of slits in the rotary encoding plate is 2,000 and the interpolating divisor is 1,000) when compared with that obtained in the conventional detecting method.

According to another aspect of the present invention, when the value of $\alpha$ making the value of V zero is calculated with the above method of the present invention, an output corresponding to the value of V is produced through the up-down counter, the cos and sin converters, and the multiplying and subtracting means, and further, the compensator for compensating the value of V, the means for generating pulses having the number corresponding to the absolute value of the output from the compensator, and the polarity detector for detecting the polarity of the output from the compensator are used to cause the up-down counter to count up or down by the predetermined number of pulses in accordance with the output signal form the polarity detector, until the value of V becomes zero. Thereby, the rotating deviation amount is detected from the obtained count value.

BRIEF DESCRIPTION OF THE DRAWINGS

Figures 1(a), 1(b), and 1(c) are waveform charts for explaining a conventional position detecting method;

Fig. 2 is a block diagram showing a basic principle of a position detecting method according to the present invention;

Figs. 3 and 4 are block diagrams of detecting devices when the position detecting method according to the present invention is carried out by means of a computer;

Fig. 5 is a flow chart of an example of a control program when detection position data is calculated by a computer with the method of the present invention; and

Fig. 6 is a block diagram of an entire arrangement when the position detecting method of the present invention is carried out by means of a feedback circuit.

BEST MODE FOR CARRYING OUT THE INVENTION

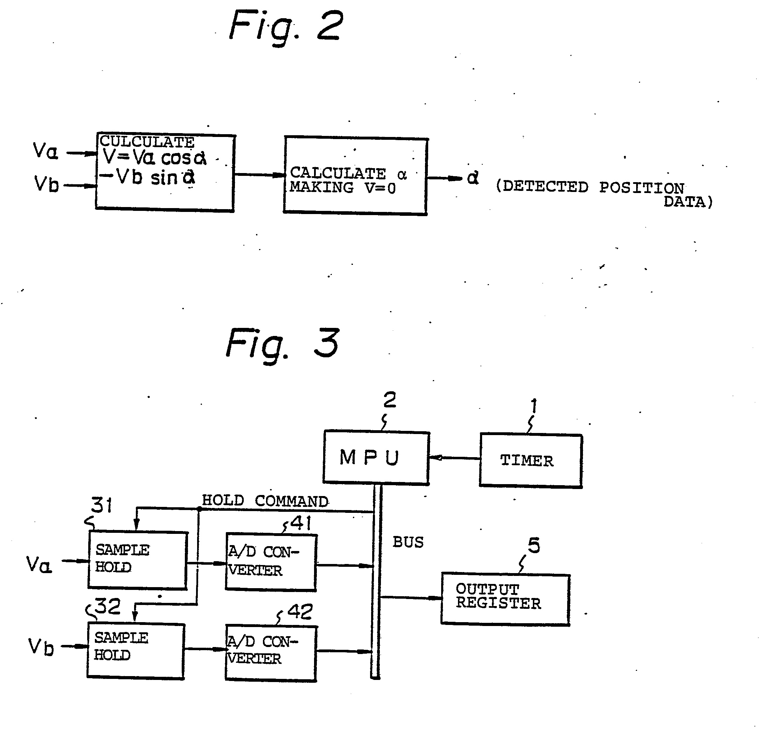

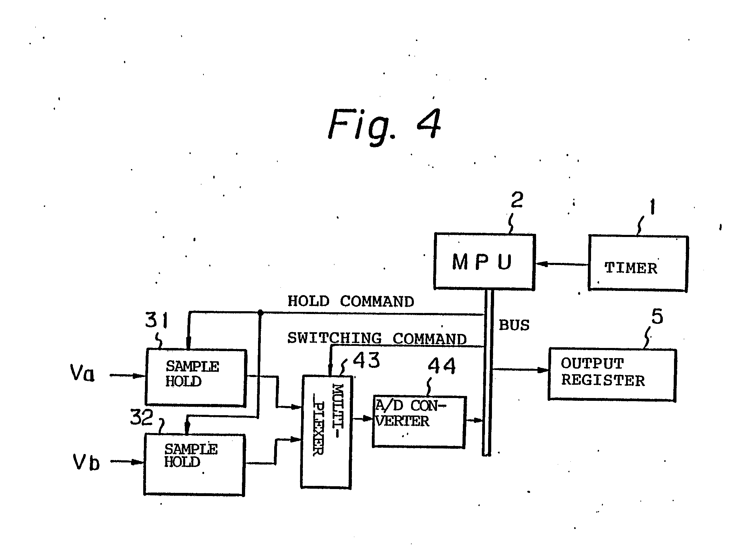

Figure 2 is a block diagram showing a basic principle of a position detecting method according to the present invention, and Figs. 3 and 4 are block diagrams of detecting devices when the position detecting method is carried out by using a computer.

According to the position detecting method of the present invention, voltage values $V_a$ and $V_b$ of two-phase sinusoidal wave signals, which are generated in accordance with the rotational angle of a rotary encoding plate (generally, the moving position of a moving object) as described in the background art, are fetched at each of constant time intervals (e.g., 50 msec), and are used to calculate $\alpha$, which makes a value V given by the following equation zero:

$$V = V_a \cdot \cos\alpha - V_b \cdot \sin\alpha.$$

The obtained $\alpha$ is used as position data (in this case, data representing the rotational angle) which is obtained by linearly interpolating and dividing (equally dividing) 1 cycle of the sinusoidal waves (corresponding to an interval between two adjacent slits on the rotary encoding plate) in accordance with a predetermined divisor.

The reason why the position data is obtained with the above method in the present invention will be described hereinafter in more detail.

In the above equation:

$$V = V_a \cdot \cos\alpha - V_b \cdot \sin\alpha \qquad \ldots (1)$$

since

$$V_a = V_0 \sin\theta, \quad V_b = V_0 \cos\theta$$

(where $V_0$ is the amplitude of the two-phase sinusoidal wave signals, and $\theta$ is the rotating position (rotational angle) of the rotary encoding plate), when these equations are substituted in equation (1),

$$V = V_0 (\sin\theta \cdot \cos\alpha - \cos\theta \cdot \sin\alpha)$$
$$= V_0 \cdot \sin(\theta - \alpha).$$

Then, the value of $\alpha$ making the value of $V$ zero is:

$$\alpha = \theta \pm n\pi \qquad \text{(where n is an integer)}.$$

Therefore, when the rotary encoding plate is rotated and $\theta$ varies, if $\alpha$ is obtained with a predetermined shorter cycle than a varying rate of $\theta$ (more specifically, a cycle shorter than a time in which the sinusoidal wave signals change by $\pi$ in accordance with rotation of the rotary encoding plate), $\theta$, i.e., the deviation amount of the rotational angle (a moving amount from its initial position) can be accurately detected by obtaining a change in $\alpha$.

Figures 3 and 4 exemplify arrangements of detecting devices when the position detecting method of the present invention is carried out by using the computer. In a detecting device shown in Fig. 3, a microprocessor 2 in the computer supplies, in response to timing signals generated by a timer 1 at predetermined intervals, a hold command to sample-hold circuits 31 and 32 (which respectively receive the sinusoidal wave signals $V_a$ and $V_b$) so as to sample and hold the current value of the sinusoidal wave signals $V_a$ and $V_b$. During this interval, the analog values of the sinusoidal wave signals $V_a$ and $V_b$ are converted into digital values by A/D converters 41 and 42, respectively, with a predetermined precision, and the digital values are input to the microprocessor 2 with each given cycle, through a bus.

In the microprocessor 2, these digital inputs are used as the values of $V_a$ and $V_b$ in equation (1), and the value of $\alpha$ making equation (1), i.e., the value of V zero, is then calculated at each cycle. Note that the calculation results for the respective cycles, i.e., position data $\alpha$ for the respective cycles can be sequentially stored in the memory of the computer or in an external output register 5.

In an apparatus shown in Fig. 4, instead of the two A/D converters 41 and 42 in Fig. 3, the outputs sampled and held by the sample-hold circuits 31 and 32 are sequentially input to a common A/D converter 44 by switching a multiplexer 43 in response to a switching command input thereto from the microprocessor 2 during each cycle, and the outputs from the converter 44 are sequentially input to the microprocessor 2, thus allowing use of a single A/D converter.

Practical methods for calculating the value of $\alpha$ making the value of V given by equation (1) zero in the microprocessor 2 will now be described.

A first method is a so-called feedback method, in which $\alpha$ for each detection cycle is calculated by the following operation.

When position data $\alpha_i$ in a certain detection cycle is to be obtained, $V_i = V_a \cdot \cos\alpha_{i-1} - V_b \cdot \sin\alpha_{i-1}$ is calculated based on position data $\alpha_{i-1}$ obtained at immediately preceding cycle and the digital values $V_a$

and $V_b$ newly input from the A/D converters 41 and 42 or the converter 44, as described previously, and new position data $\alpha_i$ is calculated as follows on the basis of the value of $V_i$ (so-called proportional compensation method):

$$\alpha_i = \alpha_{i-1} + KV_i \qquad \text{(where K is a constant)}$$
$$\dots (2).$$

Alternatively, instead of using equation (2), the values of $V_i$ are accumulated to obtain $S_i$ (i.e.,

$$S_i = S_{i-1} + V_i = \sum_{n=0}^{i} V_n),$$

and new position data $\alpha_i$ is calculated based on the $V_i$ and $S_i$ as follows (so-called proportional integral compensation method):

$$\alpha_i = \alpha_{i-1} + K_P \cdot V_i + K_s \cdot S_i \qquad \dots (3)$$

(where $K_P$ and $K_s$ are constants, and normally, $K_P > K_s$).

Note that although the proportional compensation method can be easily realized, when $\theta$ changes at a constant rate, a detection error proportional to the changing rate of $\theta$ inevitably occurs. On the other hand, although the proportional integral compensation method requires a complicated circuit, unlike the former, no detection error proportional to the changing rate of $\theta$ will occur.

In a second method, non-linear formula $V_a \cdot \cos\alpha - V_b \cdot \sin\alpha = 0$ associated with $\alpha$ is solved by the NEWTON's method. In this case, if

$$V(\alpha) = V_a \cdot \cos\alpha - V_b \sin\alpha,$$

a differentiated value $V'(\alpha)$ for $\alpha$ is given by:

$$V'(\alpha) = -V_a \cdot \sin\alpha - V_b \cos\alpha.$$

Therefore, an approximate solution of the non-linear formula can be calculated by repeating the following procedure.

When position data $\alpha_i$ of a certain detection cycle is to be obtained, the position data $\alpha_{i-1}$ of the

immediately preceding cycle is used as a initial approximate value of $\alpha_i$ (it is defined that $\alpha_{i-1}$ is equal to $\alpha_{i0}$, as $\alpha_{i0}$ corresponds to 0th approximation of $\alpha_i$), thus calculating:

$$\alpha_{i1} = \alpha_{i0} + \Delta\alpha_{i0}$$

where

$$\Delta\alpha_{i0} = -V(\alpha_{i0})/V'(\alpha_{i0}) = (V_a \cdot \cos\alpha_{i0} - V_b \cdot \sin\alpha_{i0}) / (V_a \cdot \sin\alpha_{i0} + V_b \cdot \cos\alpha_{i0}).$$

Then, $\alpha_{i1}$ is used as a first approximation of $\alpha_i$.

This operation is repeated, and if the nth approximation is $\alpha_{in}$, the $(n + 1)$th approximation is given by:

$$\alpha_{i \cdot (n + 1)} = \alpha_{in} + \Delta\alpha_{in} \quad (n = 0, 1, 2, \ldots)$$

where

$$\Delta\alpha_{in} = -V(\alpha_{in})/V'(\alpha_{in}) = (V_a \cdot \cos\alpha_{in} - V_b \cdot \sin\alpha_{in}) / (V_a \cdot \sin\alpha_{in} + V_b \cdot \cos\alpha_{in}).$$

Then, when an absolute value $|\Delta\alpha_{in}|$ of $\Delta\alpha_{in}$ satisfies $|\Delta\alpha_{in}| < \varepsilon$ (where $\varepsilon$ is a predetermined small value corresponding to a required precision), the repetition is stopped, and the position data $\alpha_i$ in that detection cycle is given by the approximate solution $\alpha_{i \cdot (n+1)}$.

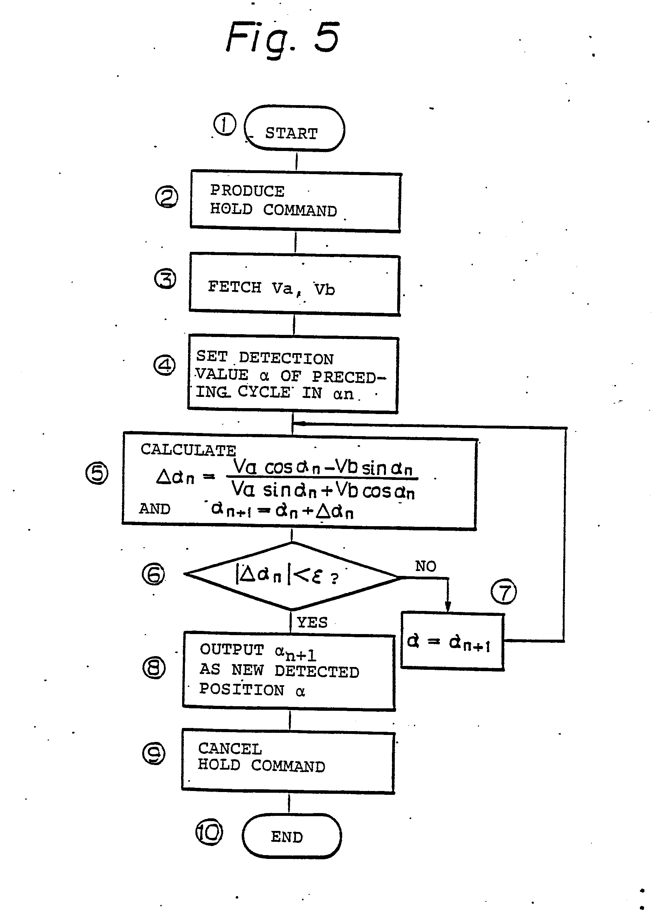

Figure 5 is a flow chart showing when the microprocessor 2 performs operation processing with the above Newton's method. Timing signals are generated from the timer 1 at equal intervals, and the microprocessor 2 initiates the next processing in response to each timing signal.

After the flow starts in step 1, the microprocessor 2 produces the hold command to the sample-hold circuits 31 and 32 in step 2, thus sampling and holding the current values of the sinusoidal wave signals $V_a$ and $V_b$ at that timing. The current analog values $V_a$ and $V_b$ are converted into the digital values of given precision by the A/D converters 41 and 42, and the digital values $V_a$ and $V_b$ are fetched in step 3.

In step 4, the detection value of the immediately preceding cycle (position data $\alpha_{i-1}$) is derived and is used as $\alpha_{i0}$.

In step 5, the following calculations are performed:

$$\Delta\alpha_n = (V_a \cdot \cos\alpha_n - V_b \cdot \sin\alpha_n)/(V_a \cdot \sin\alpha_n + V_b \cdot \cos\alpha_n)$$

and

$$\alpha_{n+1} = \alpha_n + \Delta\alpha_n$$

(where $n = 0, 1, 2, \ldots$ , and at the beginning of calculation, $n = 0$).

Next, it is judged in step 6 whether or not $|\Delta\alpha_n|$ is smaller than $\varepsilon$ (where $\varepsilon$ is a value for defining detection precision, and is given in advance). If NO in step 6, new $\alpha_n$ is given by $\alpha_{n+1}$ (step 7), and the same calculation is repeated. However, if $|\Delta\alpha_n|$ is smaller than $\varepsilon$, $\alpha_{n+1}$ is output as new detection position data $\alpha_i$ for that cycle in step 8, and the hold command is cancelled in step 9, thus completing operation processing for that cycle (step 10).

With the method of the present invention, since the value of $\alpha$ making the value of V zero will not be adversely influenced by the amplitude $V_0$ of the two-phase sinusoidal wave signals, a major cause of detection errors, an error due to the amplitude $V_0$ will not occur. Also, since the voltage values $V_a$ and $V_b$ of the sinusoidal wave signals can be fetched by an A/D converter of predetermined bits with high precision, high-precision position data obtained by linearly interpolating and dividing 1 cycle of the sinusoidal waves (corresponding to a pitch between two adjacent slits on the rotary encoding plate) by a predetermined divisor (e.g., 1,000) in accordance with the number of bits of the A/D converter, can be detected accurately.

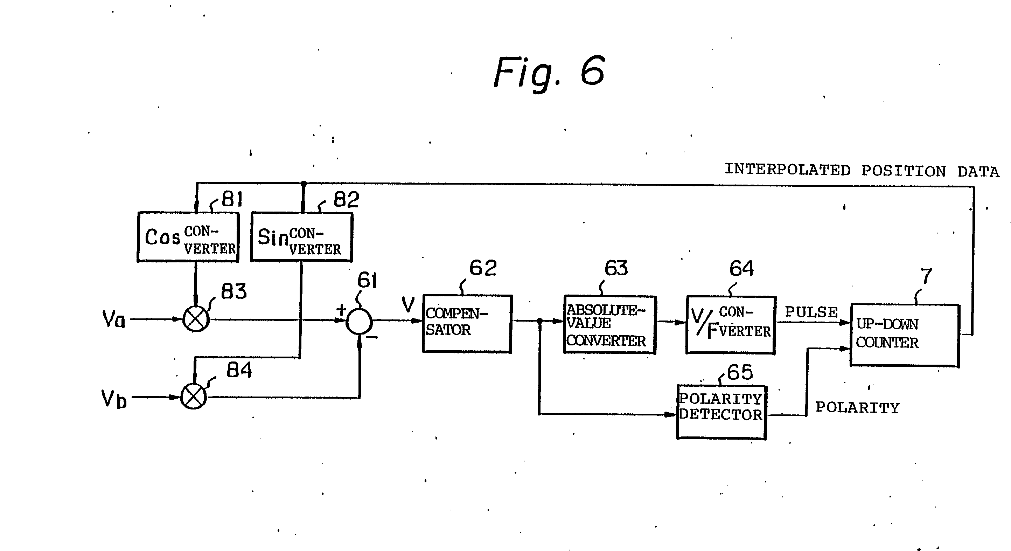

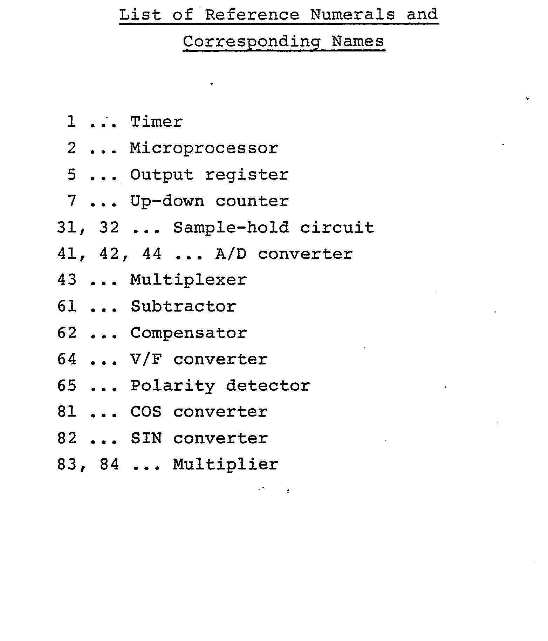

When the value of $\alpha$ in each cycle is obtained by the second method (e.g., the Newton's method), operation processing must be performed by using the computer, as previously described. However, when the value of α is calculated by the first method (so-called feedback method), the value of α can be substantially continuously obtained by using a feedback circuit, to be described with reference to Fig. 6, even if the apparatus including the computer (i.e., the microprocessor 2) shown in Fig. 3 (or Fig. 4) is not used.

More specifically, referring to Fig. 6, reference symbols $V_a$ and $V_b$ denote electrical signals obtained such that a rotary encoding plate with a large number of slits is irradiated with light, and the light, passing through the slits of the rotary encoding plate and two slits (whose pitch is shifted by 1/4 of a pitch from an integer multiple of a pitch between two adjacent slits of the rotary encoding plate) formed in a fixed plate facing the rotary encoding plate, is received by a light-receiving element such as photo diode. When the rotary encoding plate is rotated, the electrical signals $V_a$ and $V_b$ become sinusoidal wave signals having a 90°-spatial phase difference therebetween, and the voltage values are expressed as follows:

$$V_a = V_0 \cdot \sin\theta$$
$$V_b = V_0 \cdot \cos\theta$$

where θ is a value proportional to a rotational angle of the rotary encoding plate, and $\theta = 2\pi$ radians with respect to the interval between two adjacent slits (1-pitch), within which the values $V_a$ and $V_b$ change by 1 cycle.

Assuming that the count value of an up-down counter 7 in Fig. 6 is N at a certain timing, the count value N is input to a cos converter 81 and a sin converter 82 to output cosα and sinα, respectively (where $\alpha = (2\pi N)/L$, and L is an interpolating divisor with respect to the above-mentioned 1 cycle; and if L = 1,000, count values from 0 to 999 are cyclically generated from the counter 7). Note that the cos and sin converters can comprise an ROM, and the sin and cos outputs can be obtained with reference to a sin code table and a cos code table incorporated in the ROM. In this case, the count value N input to the ROM from the up-down counter is used as an address signal with. respect to the ROM.

The output $\cos\alpha$ from the cos converter 81 is multiplied with the current voltage value $V_a$ by a multiplier 83, and the output $\sin\alpha$ from the sin converter 82 is multiplied with the current voltage value $V_b$ by a multiplier 84. Then, the outputs from the multipliers 83 and 84 are input to a subtractor 61, thus generating a difference therebetween, i.e., V = $(V_a \cdot \cos\alpha - V_b \cdot \sin\alpha)$. Note that a multiplier-type D/A converter is used as a multiplier. The above $V_a$ and $V_b$ are input to the D/A converter as reference voltages, and the output (digital value) from the ROM is D/A converted in proportion to the reference voltages, thus generating the multiplied values. If a D/A converter weighted by cos and sin are used as the D/A converter, the cos and sin converters can be arranged integrally with the multipliers.

The output V is input to a compensator 62. If the compensator is a proportional compensator, KV (where K is a given constant) can be obtained from the output side.

An absolute value converter 63 derives an absolute value $|KV|$ from the output KV, and the value of $|KV|$ is input to a voltage-frequency converter 64 to be converted into a frequency proportional to the value of $|KV|$. Thereafter, pulses having the number corresponding to the frequency are generated. A polarity detector 65 produces a code corresponding to the polarity of the output KV. The up-down counter 7 receives these two outputs, and counts up or down by the given number of pulses in accordance with the code output, thus generating a new count value.

More specifically, if the value of V is not 0, the content of the up-down counter is changed by the predetermined number of pulses with a given code, and if V becomes zero, the pulse output is stopped. Thus, the feedback circuit in Fig. 6 performs a feedback operation so that the value of V becomes zero.

In this connection, when the above $V = V_a \cdot \cos\alpha - V_b \cdot \sin\alpha$ is further developed, $V_a = V_0 \sin\theta$, and $V_b = V_0 \cos\theta$, and therefore, V is given by:

$$V = V_0 (\sin\theta \cdot \cos\alpha - \cos\theta \cdot \sin\alpha)$$
$$= V_0 \sin(\theta - \alpha).$$

Therefore, when $\alpha = \theta$, that is, the count value N of the counter is equal to $(L \cdot \theta)/2\pi$, V becomes equal to zero.

In other words, $\alpha = (2\pi N)/L$ obtained when V = 0 is equal to the rotational angle of the rotary encoding plate corresponding to that timing.

When the relation $\alpha = \theta$ is established, assume that $\theta$ changes. At that time, when $\theta$ changes to the positive side and $\theta - \alpha > 0$ is yielded, the code output generated from the polarity detector 65 goes positive, the up-down counter 7 counts up by the predetermined number of pulses, and as a result, $\alpha = (2\pi N)/L$ changes to the positive side.

On the other hand, when $\theta$ changes to the negative side and $\theta - \alpha < 0$ is yielded, the code output goes negative, the up-down counter 7 counts down by the predetermined number of pulses, and as a result, $\alpha = (2\pi N)/L$ changes to the negative side. In this way, $\alpha$ follows a change in $\theta$, and the content N of the up-down counter 7 indirectly represents the rotational angle $\theta$ corresponding to that timing.

Note that the compensator 62 controls the following rate of $\alpha$ with respect to the rotational angle $\theta$, and need only have a function which performs simple amplification or attenuation with the proportional compensation. In this case, however, a detection error inevitably occurs in proportion to a rotating speed. Contrary to this, if the compensator 62 performs the proportional integral compensation (i.e., outputs the sum of a component proportional to V and a component obtained by integrating V, α can follow θ without causing a detection error as θ changes at constant rate.

According to the method and apparatus of the present invention, a moving position of a moving object can be detected, in accordance with a moving amount of the moving object from its initial position, with a remarkably high resolution when compared with that obtained in a conventional position detecting method.

CLAIMS

1. A method for detecting a position, characterized by comprising the steps of: producing two-phase sinusoidal wave signals having a 90°-spatial phase difference therebetween upon movement of a moving object; detecting the current voltage values $V_a$ and $V_b$ of the two-phase sinusoidal wave signals and calculating a value of $\alpha$ making a value of V zero, given by $V = V_a \cdot \cos\alpha - V_b \cdot \sin\alpha$; and detecting a moving amount of the moving object by using the calculated value of $\alpha$ as interpolating-dividing position data within 1 cycle of the sinusoidal wave signals.

2. An apparatus for detecting a position, characterized by comprising: means for producing two-phase sinusoidal wave signals having a 90°-spatial phase difference therebetween upon movement of a moving object; a cos converter and a sin converter for cos-converting and sin-converting a ratio of a count number of an up-down counter to an interpolating divisor within 1 cycle of the sinusoidal wave signals; two multiplying means for respectively producing a product between the output from said cos converter and the current voltage value $V_a$ of one of the two-phase sinusoidal wave signals and a product between the output from said sin converter and the current voltage value $V_b$ of the other of the two-phase sinusoidal wave signals, and subtracting means for deriving a difference V between the outputs from said two multiplying means; a compensator for compensating the value of the difference V; pulse generating means for generating pulses having a frequency proportional to an absolute value of the output from said compensator; and a polarity detector for detecting a polarity of the output from said compensator, wherein said up-down counter is caused to count up or down by a predetermined number of pulses in accordance with the output signal from said polarity detector, until the difference V becomes zero.

0200791

1/6

Fig. 1 (a)

Fig. 1 (b)

Fig. 1(c)

## Fig. 2

Va →
Vb →

CULCULATE
V = Va cos α
– Vb sin α

→

CALCULATE α
MAKING V = 0

→ α (DETECTED POSITION DATA)

## Fig. 3

2

MPU

1

TIMER

31

SAMPLE HOLD

Va →

HOLD COMMAND

41

A/D CONVERTER

32

SAMPLE HOLD

Vb →

42

A/D CONVERTER

BUS

5

OUTPUT REGISTER

Fig. 4

# Fig. 5

① ( START )

② PRODUCE HOLD COMMAND

③ FETCH Va, Vb

④ SET DETECTION VALUE α OF PRECEDING CYCLE IN $\alpha_n$

⑤ CALCULATE
$$\Delta\alpha_n = \frac{Va\cos\alpha_n - Vb\sin\alpha_n}{Va\sin\alpha_n + Vb\cos\alpha_n}$$
AND $\alpha_{n+1} = \alpha_n + \Delta\alpha_n$

⑥ $|\Delta\alpha_n| < \varepsilon$ ?  NO → ⑦ $\alpha = \alpha_{n+1}$

YES

⑧ OUTPUT $\alpha_{n+1}$ AS NEW DETECTED POSITION α

⑨ CANCEL HOLD COMMAND

⑩ ( END )

# Fig. 6

INTERPOLATED POSITION DATA

Cos CON-VERTER **81**

Sin CON-VERTER **82**

Va ⊗ **83**

Vb ⊗ **84**

**61** + / −  V

COMPEN-SATOR **62**

ABSOLUTE-VALUE CONVERTER **63**

V/F CON-VERTER **64**  PULSE

UP-DOWN COUNTER **7**

POLARITY DETECTOR **65**  POLARITY

5/6

0200791

0200791

## List of Reference Numerals and
## Corresponding Names

1 ... Timer

2 ... Microprocessor

5 ... Output register

7 ... Up-down counter

31, 32 ... Sample-hold circuit

41, 42, 44 ... A/D converter

43 ... Multiplexer

61 ... Subtractor

62 ... Compensator

64 ... V/F converter

65 ... Polarity detector

81 ... COS converter

82 ... SIN converter

83, 84 ... Multiplier

# INTERNATIONAL SEARCH REPORT

0200791

International Application No. PCT/JP85/00612

## I. CLASSIFICATION OF SUBJECT MATTER (if several classification symbols apply, indicate all) [1]

According to International Patent Classification (IPC) or to both National Classification and IPC

Int.Cl[4]  G01B 7/00, G01B 21/00, G01D 5/245

## II. FIELDS SEARCHED

| Minimum Documentation Searched [4] | |
|---|---|
| Classification System | Classification Symbols |
| IPC | G01B 21/00, G01B 7/00, G01D 5/245 |

| Documentation Searched other than Minimum Documentation to the Extent that such Documents are Included in the Fields Searched [5] | |
|---|---|
| Jitsuyo Shinan Koho | 1935 - 1985 |
| Kokai Jitsuyo Shinan Koho | 1971 - 1985 |

## III. DOCUMENTS CONSIDERED TO BE RELEVANT [14]

| Category [*] | Citation of Document, [16] with indication, where appropriate, of the relevant passages [17] | Relevant to Claim No. [18] |
|---|---|---|
| A | JP, B1, 47-5073 (Sony Corp.), 12 February 1972 (12. 02. 72) (Family: none) | 1 |
| X | JP. A. 60-157014 (Tokyo Kogaku Kikai Kabushiki Kaisha), 17 August 1985 (17. 08. 85) Page 4, lower right column to page 5, upper right column (Family: none) | 1, 2 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| January 16, 1986 (16. 01. 86) | January 27, 1986 (27. 01. 86) |
| International Searching Authority [1] | Signature of Authorized Officer [20] |
| Japanese Patent Office | |

Form PCT/ISA/210 (second sheet) (October 1981)